# EUROPÄISCHE PATENTSCHRIFT

(11) **EP 3 968 437 B1**
(45) Veröffentlichungstag und Bekanntmachung des Hinweises auf die Patenterteilung: **12.03.2025**
(21) Anmeldenummer: 21195564.6
(22) Anmeldetag: 08.09.2021
(51) Int. Cl.: H01M 10/48, G01R 31/367

(54) **VERFAHREN ZUM TRAINIEREN EINES MASCHINENMODELLS ZUR BESTIMMUNG EINES BATTERIESYSTEMZUSTANDS**
METHOD FOR TRAINING A MACHINE MODEL FOR DETERMINING A BATTERY SYSTEM STATUS
PROCÉDÉ D'APPRENTISSAGE D'UN MODÈLE DE MACHINE POUR DÉTERMINER L'ÉTAT D'UN SYSTÈME DE BATTERIE

(30) Priorität: 11.09.2020 DE 102020123794
(43) Veröffentlichungstag der Anmeldung: 16.03.2022
(73) Patentinhaber: TWAICE Technologies GmbH, 80807 München (DE)
(72) Erfinder: GRUNZKE, Richard, 81377 München (DE); KEIL, Jonas, 80337 München (DE); WANISCH, Manuel, 80639 München (DE); SINGER, Jan, 80337 München (DE)
(74) Vertreter: Kraus & Lederer PartGmbB

(56) Entgegenhaltungen:
- DE-B4- 102004 004 280
- DE-T5- 112017 000 274
- US-A1- 2016 349 330
- VATANI MOHSEN ET AL: "Cycling Lifetime Prediction Model for Lithium-ion Batteries Based on Artificial Neural Networks", 2018 IEEE PES INNOVATIVE SMART GRID TECHNOLOGIES CONFERENCE EUROPE (ISGT-EUROPE), IEEE, 21 October 2018 (2018-10-21), pages 1 - 6, XP033472049, DOI: 10.1109/ISGTEUROPE.2018.8571814

## Beschreibung

Mit zunehmender Verbreitung von Batteriesystemen als Energiequelle für Transportfahrzeuge kommt der Analyse des Alterungsverhaltens dieser Batteriesysteme steigende Bedeutung zu.

Eine Simulation des Alterungsverhaltens und der Vorhersage (Prädiktion) eines (zukünftigen) Batteriesystemzustands setzt oftmals ein batteriezellenspezifisches Alterungsmodell voraus, dessen Alterungsparameter aufwendig im Labor ermittelt werden müssen. Dies ist zeit- und kostenintensiv. Darüber hinaus ist das Alterungsmodell häufig nur für Batteriesysteme gültig, die diesen spezifischen Batteriezelltyp aufweisen. VATANI MOHSEN ET AL: "Cycling Lifetime Prediction Model for Lithium-ion Batteries Based on Artificial Neural Networks",2018 IEEE PES INNOVATIVE SMART GRID TECHNOLOGIES CONFERENCE EUROPE (ISGT-EUROPE), IEEE, 21. Oktober 2018 , Seiten 1-6, offenbart ein Verfahren zum Trainieren eines Maschinenmodells.

Aufgabe der vorliegenden Erfindung ist es, die bekannten Verfahren zu verbessern. Vorgeschlagen wird ein Verfahren zum Trainieren eines Maschinenmodells zur Beschreibung eines Batteriesystems, umfassend: Bereitstellen von Trainingsdaten, welche konstante Batteriebeschreibungsvektoren und für diese Batteriebeschreibungsvektoren jeweils eine Folge von zeitlich aufeinanderfolgenden Messwertvektoren umfassen, Prozessieren der Trainingsdaten in dem Maschinenmodell, wobei ein simulierter Batteriesystemzustand erhalten wird, Bereitstellen einer Kostenfunktion, die eine Abweichung des simulierten Batteriesystemzustands von einem Referenzbatteriezustand beschreibt, und Trainieren des Maschinenmodells, wobei durch Anpassung von Parametern des Maschinenmodells die Kostenfunktion minimiert wird.

Die Batteriebeschreibungsvektoren beschreiben dabei Eigenschaften des Batteriesystems, die sich im Laufe der Zeit nicht ändern. Die Messwertvektoren beschreiben Batteriesystemzustände von verschiedenen Variablen, die im Laufe der Zeit gemessen werden.

Der simulierte Batteriesystemzustand kann dabei einem aktuellen Batteriesystemzustand entsprechen oder einem zukünftigen Batteriesystemzustand. Wenn es sich um einen zukünftigen Batteriesystemzustand handelt, kann auch von einer Prädiktion eines Batteriesystemzustands gesprochen werden.

Mit dem beanspruchten Verfahren kann die Menge der Daten, welche für ein gutes Training des Maschinenmodells erforderlich ist, erhöht werden. Beispielsweise werden für die Vorhersage einer Lebensdauer (end of life, EOL) typischerweise Messwertvektoren von Batteriesystemen benötigt, die das Ende der Lebensdauer erreicht haben. In vielen Fällen stehen solche Messwertvektoren nicht für alle Batteriezelltypen zur Verfügung. Durch die gemeinsame Verarbeitung von verschiedenen Batteriesystemen, die jeweils durch Batteriebeschreibungsvektoren beschrieben werden, können Vorhersagen auch für Batteriesysteme ermöglicht werden, zu denen keine vollständigen Sätze von zeitlich aufeinanderfolgenden Messwertvektoren, die im Laborversuch erhalten wurden, vorliegen.

Eine Ausgestaltung des Verfahrens sieht vor, dass das Anpassen von Parametern des Maschinenmodells unter Randwertbedingungen erfolgt. Die Vorgabe von Randwertbedingungen kann zu einer besseren Qualität des Maschinenmodells beitragen.

Beispielsweise können die Randwertbedingungen vorgeben, dass sich ein bestimmter Batteriesystemzustand des Messwertvektors über die Zeit nur monoton ändern darf. Ebenso ist es denkbar vorzugeben, dass die Batteriesystemzustände einer bestimmten statistischen Verteilung unterliegen müssen. Weiter können die Randwertbedingungen bekannte Zusammenhänge zwischen unterschiedlichen physikalischen Größen der Messwertvektoren umfassen.

In Ausgestaltungen des Verfahrens ist vorgesehen, dass die Parameter des Maschinenmodells wenigstens einen Parameter umfassen, der eine zeitliche Verteilung wenigstens eines Messwerts des Messwertsvektors beschreibt.

Weitere Ausgestaltungen können vorsehen, dass die Randwertbedingungen ein Minima und/oder ein Maxima eines Parameterwerts umfassen. Beispielsweise können die Randwertbedingungen vorgeben, dass die Ladung des Batteriesystems einen Maximalwert nicht überschreiten darf.

Die Randwertbedingungen können bekannte Zusammenhänge zwischen unterschiedlichen physikalischen Größen der Messwertvektoren umfassen.

Beispielsweise kann im Rahmen des beschriebenen Verfahrens berücksichtigt werden, dass ein Stromfluss eine Erwärmung des Batteriesystems bewirkt. Ebenso kann berücksichtigt werden, dass zum Ende der Lebensdauer eine Temperaturerhöhung bei einem Stromfluss durch das Batteriesystem höher sein kann als zu Beginn der Lebensdauer (beginning of life, BOL). Dies kann Rückschlüsse auf die Impedanz des Batteriesystems sowie eine Zunahme der Impedanz bei der Alterung des Batteriesystems ermöglichen. Weiter ist denkbar, dass im Rahmen des vorgeschlagenen Verfahrens berücksichtigt wird, dass beim BOL die Batteriezellen des Batteriesystems schneller bei Abschaltung eines durch das Batteriesystem fließenden Stroms relaxieren als beim EOL. Dies kann eine Ursache darin haben, dass Strom- und Potenzialdichten mit zunehmender Lebensdauer des Batteriesystems inhomogener werden. Im Zusammenhang mit Temperaturmessungen kann weiter berücksichtigt werden, dass in Abhängigkeit der Jahreszeit und des momentanen Ortes des Batteriesystems, welcher beispielsweise durch die NSS-Systeme, insbesondere GPS, festgestellt werden kann, beeinflusst werden und nicht ausschließlich durch den durch das Batteriesystem fließenden Strom. Ferner erlaubt es das Verfahren, auch ein Ähnlichkeitsmaß zwischen verschiedenen Zellchemien und die räumliche Nähe von Batteriezellen in dem Batteriesystem zu berücksichtigen. Durch das Nutzen dieser vielfältigen Informationen lässt sich das Training von dem beschriebenen Maschinenmodell maßgeblich verbessern.

Die Messwertvektoren, die im Zusammenhang mit dem beschriebenen Verfahren ausgewertet werden, können insbesondere Stromwerte und/oder Spannungswerte und/oder Temperaturwerte umfassen. Es ist ebenfalls denkbar, dass die Messwertvektoren einen Ort des Batteriesystems umfassen. Weiter kann auch eine Jahreszeit oder Saison berücksichtigt werden (zum Beispiel Winter, Sommer; Trockenzeit, Regenzeit).

Die Batteriebeschreibungsvektoren, das heißt Eigenschaften des Batteriesystems, welche über die Lebensdauer des Batteriesystems unverändert bleiben, können eine Zellchemie einer Batteriezelle des Batteriesystems und/oder eine physikalische Struktur einer Batteriezelle des Batteriesystems und/oder eine Anzahl von Batteriezellen des Batteriesystems und/oder eine Verschaltungsarchitektur von Batterien des Batteriesystems und/oder eine Nennenergiedichte des Batteriesystems und/oder eine Nennleistungsdichte des Batteriesystems beschreiben.

Die Zellchemie kann beispielsweise Angaben zum Kathodenmaterial und/oder zum Anodenmaterial und/oder zur Geometrie des Kathoden-und/oder Anodenmaterials und/oder zum Elektrolyt umfassen.

Angaben zum Kathodenmaterial können Angaben zum Aktivmaterial umfassen. Beispielsweise kann das Aktivmaterial des Kathodenmaterials Nickel und/oder Mangan und/oder Kobalt und/oder Eisen und/oder Phosphor umfassen. Weiter können die Angaben eine genaue Zusammensetzung angeben (zum Beispiel Li₍₁₋ₓ₎Ni_{1/3} Mn_{1/3} C_{1/3} O₂). Weiter kann angegeben werden, ob und gegebenenfalls welches Leitmaterial (zum Beispiel x Prozent Graphit) zugegeben wird. Ferner können Additive, die für die Prozessierbarkeit des Kathodenmaterials und/oder die Lebensdauer zugegeben werden, von den Angaben zum Kathodenmaterial umfasst sein.

Zum Anodenmaterial kann ebenfalls das Aktivmaterial (zum Beispiel Graphit, Silicium, Lithium (Metall)), dessen genaue Zusammensetzung (zum Beispiel Liₓ C₆), die Art des Graphits (zum Beispiel needls coke, MCMB, Graphene) und/oder Additive, die für die Prozessierbarkeit, Lebensdauer etc. zugegeben werden, angegeben werden.

Zu dem Kathodenmaterial und/oder Anodenmaterial können zudem Schichtdicken und/oder Porositäten und/oder Tortuosität angegeben werden.

Die physikalische Struktur kann insbesondere Angaben zur Batteriezellengröße und/oder Elektrodenfläche und/oder zur Zahl der Ableiter und/oder zur Position und/oder zur Bauform umfassen.

Die Bauformen der Batteriezellen können beispielsweise Rundzellen, welche auch als zylindrische Zellen bezeichnet werden können, prismatische Zellen und/oder Pouchzellen, welche auch als Coffee-Bag-Zellen bezeichnet werden, umfassen.

Weitere Angaben, die grundsätzlich berücksichtigt werden können, sind äußere Faktoren wie Kühlsysteme und deren Topologien, Verspannungen der Module und des Systems, und/oder ein gemessener Druck im System sowie möglicherweise verbaute Phase-Change-Materialien (PCM).

Weiter wird ein Verfahren zur Bestimmung eines Batteriesystemzustands vorgeschlagen, welches umfasst: Bereitstellen eines konstanten Batteriebeschreibungsvektors und einer Folge von zeitlich aufeinanderfolgenden Messvektoren, und Prozessieren des Batteriebeschreibungsvektors sowie der Folge der zeitlich aufeinanderfolgenden Messwertvektoren in einem oben beschriebenen Maschinenmodell, wobei der Batteriezustand erhalten wird.

Darüber hinaus betrifft die vorliegende Offenbarung eine Vorrichtung zur Bestimmung eines Batteriesystemzustands, welche Verarbeitungsmittel umfasst, die zur Durchführung eines der oben beschriebenen Verfahren geeignet sind.

Ausführungsbeispiele werden im Folgenden mit Hilfe der Zeichnungen veranschaulicht.

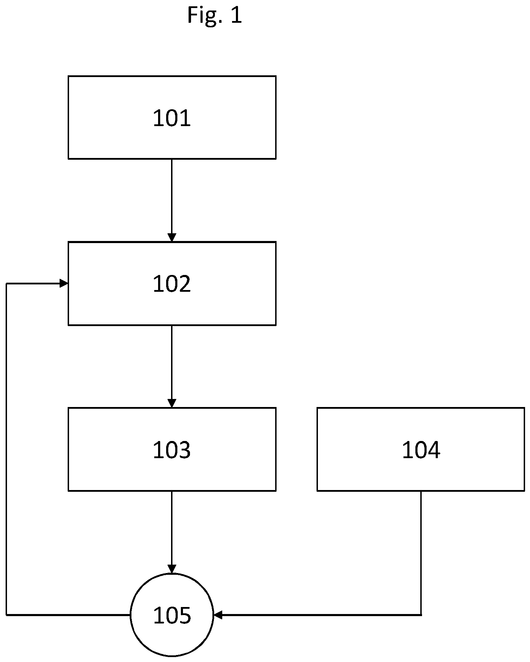

Fig. 1 zeigt ein Ausführungsbeispiel eines Verfahrens zum Trainieren eines Maschinenmodells. Das Verfahren umfasst das Bereitstellen von Trainingsdaten 101, welche konstante Batteriebeschreibungsvektoren und für diese Batteriebeschreibungsvektoren jeweils eine Folge von zeitlich aufeinanderfolgenden Messwertvektoren umfassen. Die Trainingsdaten 101 werden in einem Maschinenmodell 102 prozessiert, wobei ein simulierter Batteriesystemzustand 103 erhalten wird. Weiter wird eine Kostenfunktion 105 bereitgestellt, die eine Abweichung des simulierten Batteriesystemzustands 103 von einem Referenzbatteriezustand 104 beschreibt. Das Maschinenmodell 102 wird trainiert, wobei durch Anpassung von Parametern des Maschinenmodells die Kostenfunktion 105 minimiert wird.

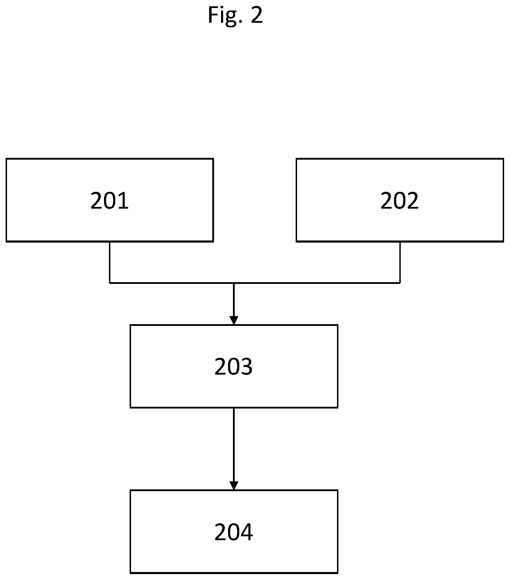

Fig. 2 zeigt beispielhaft ein Verfahren zur Bestimmung eines Batteriesystemzustands. Es wird ein konstanter Batteriebeschreibungsvektor 201 und eine Folge von zeitlich aufeinanderfolgenden Messwertvektoren 202 bereitgestellt, welche in einem Maschinenmodell 203 prozessiert werden, wobei ein Batteriesystemzustand 204 erhalten wird. Das Maschinenmodell 203 kann insbesondere mit dem in der Fig. 1 beschriebenen Verfahren trainiert worden sein.

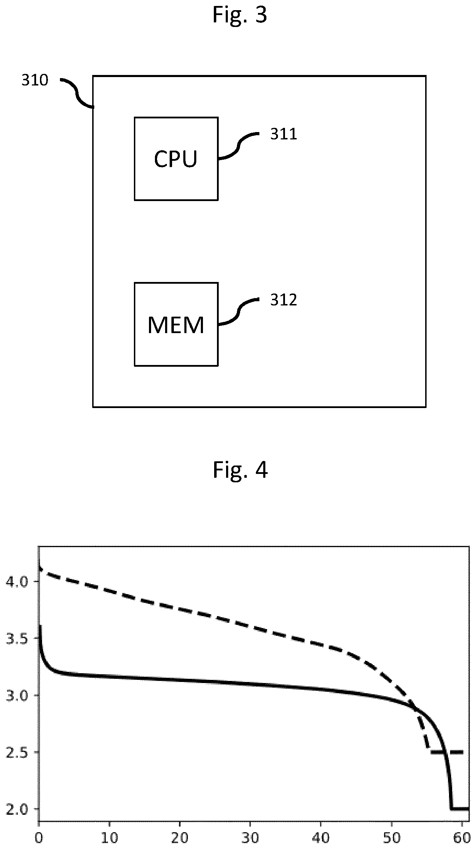

Fig. 3 zeigt eine Vorrichtung zur Bestimmung eines Batteriesystemzustands 310. Die Vorrichtung 310 umfasst eine Recheneinheit 311 und einen Speicher 312. Die Recheneinheit 311 ist dazu eingerichtet, das Verfahren nach Fig. 1 oder Fig. 2 durchzuführen.

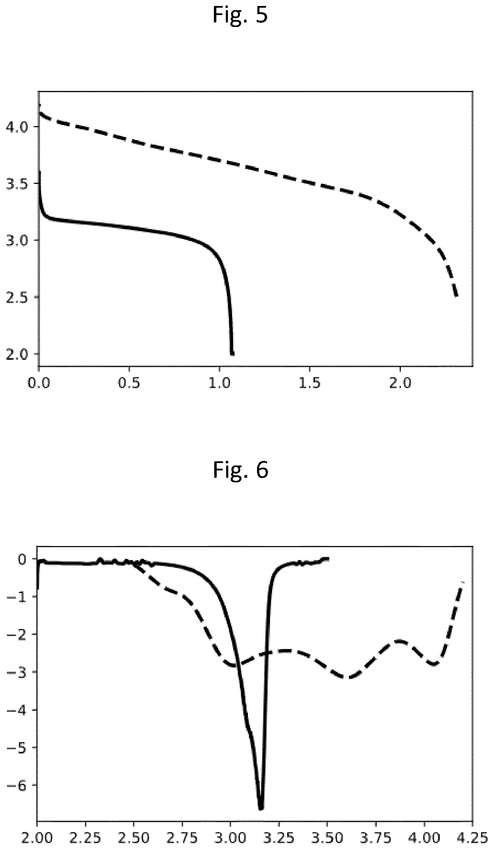

Fig. 4, Fig. 5 und Fig. 6 illustrieren beispielhafte Verläufe von Messwertvektoren für zwei verschiedene Batteriebeschreibungsvektoren, welche zwei verschiedene Batteriesysteme charakterisieren.

Bei beiden Batteriesystemen handelt es sich um einzelne Rundzellen, insbesondere 18650 Rundzellen. Die Batteriesysteme unterscheiden sich nicht durch die Bauform, sondern nur durch die verwendete Zellchemie, insbesondere durch Unterschiede im verwendeten Anoden- und Kathodenmaterial.

Die in den Figuren 4 bis 6 gestrichelt dargestellten Kurven betreffen eine Lithium-Eisen-Phosphat-Zelle (LFP-Zelle) und die mit einer durchgängigen Linie dargestellten Messwerte eine Lithium-Nickel-Mangan-Cobalt-Zelle (NMC-Zelle).

Fig. 4 zeigt eine Entladekennlinie für die beiden verschiedenen Zellen. Aufgetragen ist die Spannung in Volt über der Zeit in Minuten. Die beiden Zellen wurden dabei mit einer konstanten Entladerate von 1C entladen, die einer vollen Entladung der Zelle innerhalb einer Stunde entspricht.

Aus den Kennlinien wird deutlich, dass die sich die Steigungen der beiden Kurven deutlich unterscheiden. Ebenso unterscheiden sich die Spannungsgrenzen, die bei der LFP-Zelle zwischen 2,0 V und 3,6 V und bei der NMC-Zelle zwischen 2,5 und 4,2 V liegen.

In der Fig. 5 ist die Spannung in Volt über der der jeweiligen Zelle entnommenen Ladung in Ah aufgetragen. Der Fig. 5 lässt sich entnehmen, dass die LFP-Zelle über eine Kapazität von 1,1 Ah und die NMC-Zelle über eine Kapazität von 2,5 Ah verfügt. Weiter lässt sich erkennen, dass sich der Spannungsverlauf in Abhängig von der entnommenen Ladung, welche mit dem Ladezustand (SOC) der Zelle korrespondiert, unterscheidet.

Fig. 6 illustrierte wie viel Ladungsänderung, welcher Spannungsänderung entspricht. Aufgetragen ist die Ladungsänderung dQ/dV in Ah pro Volt über der Spannung in Volt.

Den Figuren 4 bis 6 lässt sich entnehmen, dass sich die Messwertvektoren und die entsprechenden abgeleiteten Größen für verschiedene konstante Batteriebeschreibungsvektoren deutlich unterscheiden.

Das vorgeschlagene Verfahren ermöglicht es, ein Maschinenmodell für viele verschiedene Batteriesysteme gemeinsam zu trainieren, und somit auch für Batteriesysteme Vorhersagen zu treffen, für welche nur wenige Messwertvektorverläufe vorliegen.

## Patentansprüche

1. Verfahren zum Trainieren eines Maschinenmodells zur Beschreibung eines Batteriesystems umfassend:
- Bereitstellen von Trainingsdaten, welche
konstante Batteriebeschreibungsvektoren und für diese Batteriebeschreibungsvektoren jeweils eine Folge von zeitlich aufeinanderfolgenden Messwertvektoren umfassen,
- Prozessieren der Trainingsdaten in dem Maschinenmodell, wobei ein simulierter Batteriesystemzustand erhalten wird,
- Bereitstellen einer Kostenfunktion, die eine Abweichung des simulierten Batteriezustands von einem Referenzbatteriezustand beschreibt,
- Trainieren des Maschinenmodells, wobei durch Anpassung von Parametern des Maschinenmodells die Kostenfunktion minimiert wird.

2. Verfahren nach Patentanspruch 1,
wobei das Anpassen von Parametern des Maschinenmodells unter Randwertbedingungen erfolgt.

3. Verfahren nach Patentanspruch 1 oder 2,
wobei die Parameter des Maschinenmodells wenigstens einen Parameter umfassen, der eine zeitliche Verteilung wenigstens eines Messwerts des Messwertvektors beschreibt.

4. Verfahren nach Patentanspruch 2 oder 3,
wobei die Randwertbedingungen ein Minima und/oder ein Maxima eines Parameterwerts umfassen.

5. Verfahren nach einem der Patentansprüche 2 bis 4,
wobei die Randwertbedingungen bekannte Zusammenhänge zwischen unterschiedlichen physikalischen Größen der Messwertvektoren umfassen.

6. Verfahren nach einem der Patentansprüche 1 bis 5,
wobei die Messwertvektoren
Stromwerte und/oder
Spannungswerte und/oder
Temperaturwerte
umfassen.

7. Verfahren nach einem der Patentansprüche 1 bis 6,
wobei die Batteriebeschreibungsvektoren
eine Zellchemie einer Batteriezelle des Batteriesystem und/oder
eine physikalische Struktur einer Batteriezelle des Batteriesystems und/oder
eine Anzahl von Batteriezellen des Batteriesystems und/oder
eine Verschaltungsarchitektur von Batteriezellen des Batteriesystem und/oder
eine Nennenergiedichte des Batteriesystems und/oder
eine Nennleistungsdichte des Batteriesystems beschreiben.

8. Verfahren nach Patentanspruch 7,
wobei die Zellchemie Angaben
zum Kathodenmaterial und/oder
zum Anodenmaterial und/oder
zur Stöchiometrie des Kathoden- und/oder Anodenmaterials und/oder
zum Elektrolyt
umfasst.

9. Verfahren nach Patentanspruch 7 oder 8,
wobei die physikalische Struktur Angaben
zur Batteriezellgröße,
zur Elektrodenfläche,
zur Zahl der Ableiter,
zur Position der Ableiter,
zur Bauform
umfasst.

10. Verfahren zur Bestimmung eines Batteriesystemzustands umfassend
- Bereitstellen
eines konstanten Batteriebeschreibungsvektors und
einer Folge von zeitlich aufeinanderfolgenden Messwertvektoren,
- Prozessieren des Batteriebeschreibungsvektors und der Folge der zeitlich aufeinanderfolgenden Messwertvektoren in einem Maschinenmodell nach einem der Patentansprüche 1 bis 9 trainierten Maschinenmodell, wobei der Batteriesystemzustand erhalten wird.

## Claims

1. Method for training a machine model for describing a battery system, comprising:
- Provision of training data, which comprise constant descriptive battery vectors and, in each case, for these descriptive battery vectors, a series of temporally sequential measurement value vectors;
- Processing of training data in the machine model, wherein a simulated battery system state is obtained;
- Provision of a cost function, which describes a deviation of the simulated battery system state from a reference battery state;
- Training of the machine model wherein, by the adjustment of parameters of the machine model, the cost function is minimized.

2. Method according to patent Claim 1,
wherein the adjustment of parameters of the machine model is executed under marginal value conditions.

3. Method according to patent Claim 1 or 2,
wherein parameters of the machine model comprise at least one parameter which describes a temporal distribution of at least one measurement value of the measurement value vector.

4. Method according to patent Claim 2 or 3,
wherein marginal value conditions comprise a minimum and/or a maximum parameter value.

5. Method according to one of patent claims 2 to 4.
wherein marginal value conditions comprise known relationships between different physical variables of measurement value vectors.

6. Method according to one of patent Claims 1 to 5,
wherein measurement value vectors comprise:
current values, and/or
voltage values, and/or
temperature values.

7. Method according to one of patent Claims 1 to 6,
wherein the descriptive battery vectors describe:
a cell chemistry of a battery cell of the battery system, and/or
a physical structure of a battery cell of the battery system, and/or
a number of battery cells of the battery system, and/or
a circuit architecture of batteries of the battery system, and/or
a rated energy density of the battery system, and/or
a rated power density of the battery system.

8. Method according to patent Claim 7,
wherein the cell chemistry comprises data:
on the cathode material, and/or
on the anode material, and/or
on the stoichiometry of the cathode and/or anode material, and/or
on the electrolyte.

9. Method according to patent Claim 7 or 8,
wherein the physical structure comprises data:
on the battery cell size,
on the electrode surface area,
on the number of diverters,
on the position of diverters,
on the structural design.

10. Method for determining a state of a battery system, comprising:
- Provision of a constant descriptive battery vector and of a series of temporally sequential measurement vectors, and
- Processing of the descriptive battery vector and of the series of temporally sequential measurement vectors in a machine model according to one of patent Claims 1 to 9, wherein the battery system state is obtained.

## Revendications

1. Procédé d'apprentissage d'un modèle de machine destiné à décrire un système de batterie, ledit procédé comprenant les étapes suivantes :
- fournir des données d'apprentissage qui comprennent des vecteurs de description de batterie constants et, pour ces vecteurs de description de batterie, une séquence de vecteurs de valeurs de mesure temporellement successifs,
- traiter les données d'apprentissage dans le modèle de machine, un état de système de batterie simulé étant obtenu,
- fournir une fonction de coût qui décrit un écart entre l'état de batterie simulé et un état de batterie de référence,
- apprendre le modèle de machine, la fonction de coût étant minimisée par ajustement des paramètres du modèle de machine.

2. Procédé selon la revendication 1,
les paramètres du modèle de machine étant ajustés dans des conditions de valeurs limites.

3. Procédé selon la revendication 1 ou 2,
les paramètres du modèle de machine comprenant au moins un paramètre qui décrit une distribution temporelle d'au moins une valeur de mesure du vecteur de valeurs de mesure.

4. Procédé selon la revendication 2 ou 3,
les conditions de valeur limite comprenant un minimum et/ou un maximum d'une valeur de paramètre.

5. Procédé selon l'une des revendications 2 à 4,
les conditions de valeurs limites incluant des relations connues entre différentes grandeurs physiques des vecteurs de valeurs de mesure.

6. Procédé selon l'une des revendications 1 à 5,
les vecteurs de valeurs de mesure comprenant
des valeurs de courant et/ou
des valeurs de tension et/ou
des valeurs de température.

7. Procédé selon l'une des revendications 1 à 6,
les vecteurs de description de batterie décrivant
une chimie de cellule d'une cellule de batterie du système de batterie et/ou
une structure physique d'une cellule de batterie du système de batterie et/ou
un nombre de cellules de batterie du système de batterie et/ou
une architecture d'interconnexion de cellules de batterie du système de batterie et/ou
une densité d'énergie nominale du système de batterie et/ou
une densité de puissance nominale du système de batterie.

8. Procédé selon la revendication 7,
la chimie de cellule comprenant des informations sur le matériau cathodique et/ou
le matériau anodique et/ou
la stœchiométrie du matériau cathodique et/ou du matériau anodique et/ou
l'électrolyte.

9. Procédé selon la revendication 7 ou 8,
la structure physique comprenant des informations sur
la taille des cellules de batterie,
la surface des électrodes,
le nombre de déflecteurs,
la position des déflecteurs et
la conception.

10. Procédé de détermination d'un état de système de batterie comprenant les étapes suivantes
- fournir un vecteur de description de batterie constant et une séquence de vecteurs de valeurs de mesure temporellement successifs,
- traiter le vecteur de description de batterie et la séquence de vecteurs de valeurs de mesure temporellement successifs dans un modèle de machine dont l'apprentissage est effectué selon l'une des revendications 1 à 9, l'état de système de batterie étant obtenu.
